(19)

Europäisches Patentamt
European Patent Office
Office européen des brevets

(11) **EP 3 162 856 A1**

(12) **EUROPEAN PATENT APPLICATION**
published in accordance with Art. 153(4) EPC

(43) Date of publication:
**03.05.2017 Bulletin 2017/18**

(21) Application number: **15811755.6**

(22) Date of filing: **23.06.2015**

(51) Int Cl.:
*C08L 77/06* (2006.01)        *C08K 3/00* (2006.01)
*C08L 67/02* (2006.01)        *G02B 1/04* (2006.01)
*G02B 5/08* (2006.01)         *H01L 33/60* (2010.01)

(86) International application number:
**PCT/JP2015/067996**

(87) International publication number:
**WO 2015/199062 (30.12.2015 Gazette 2015/52)**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA**

(30) Priority: **25.06.2014   JP 2014130406**

(71) Applicant: **Unitika, Ltd.**
**Amagasaki-shi, Hyogo 660-0824 (JP)**

(72) Inventors:
• **KABASHIMA Yohei**
  **Uji-shi,**
  **Kyoto 611-0021 (JP)**

• **KAMIKAWA Hiroo**
  **Uji-shi,**
  **Kyoto 611-0021 (JP)**
• **MII Junichi**
  **Uji-shi,**
  **Kyoto 611-0021 (JP)**
• **AMARI Taiyo**
  **Uji-shi,**
  **Kyoto 611-0021 (JP)**

(74) Representative: **Vigand, Philippe et al**
**Novagraaf International SA**
**Chemin de l'Echo 3**
**1213 Onex - Genève (CH)**

(54) **RESIN COMPOSITION AND MOLDED ARTICLE THEREOF**

(57)     Disclosed is a resin composition including a polyamide (A), a polyester (B) and a white pigment (C), wherein (A) has a melting point of 280°C or higher, (B) is polycyclohexylenedimethylene terephthalate, a mass ratio (A/B) is 5/95 to 95/5, and a content of (C) is 10 to 150 parts by mass in relation to 100 parts by mass of a total amount of (A) and (B).

EP 3 162 856 A1

**Description**

Technical Field

The present invention relates to a resin composition excellent in heat resistance and reflectance, and suitable for an LED reflection plate.

Background Art

The light emitting diode (LED) undergoes, as a novel light source, a rapidly expanding demand as illuminating elements and display elements, from the viewpoint of low electric power consumption and long operating life, and the development of large size and high power LEDs has also progressed. In the LED, a reflection plate doubling as housing is an important constituent component for efficiently using light. The resin material to be used for the reflection plate is required to have, in addition to excellent reflectance, the heat resistance (reflow resistance) to the reflow soldering step common in mounting in an electronic board.

As such resin materials, semi-aromatic polyamide resin compositions containing titanium oxide or calcium carbonate are known. For example, Patent Literature 1 discloses a resin composition including polynonamethylene terephthalamide (PA9T) and titanium oxide, and Patent Literature 2 discloses resin compositions including a polyhexamethylene terephthalamide (PA6T) based copolymer resin or a polydecamethylene terephthalamide (PA10T) based copolymer resin, and titanium oxide, calcium carbonate and glass fiber.

Citation List

Patent Literature

Patent Literature 1: JP2004-75994A
Patent Literature 2: JP2011-241398A

Summary of Invention

Technical Problem

However, when the reflection plates obtained from the semi-aromatic polyamide resin compositions of Patent Literature 1 and Patent Literature 2 were exposed to heat for a long period of time, the reflectance was degraded and the reflectance was hardly maintained.

The present invention solves the above-described technical problem, and an object of the present invention is to provide a resin composition capable of constituting a reflection plate having reflow resistance, and at the same time, being suppressed in the reflectance degradation even when exposed to heat for a long time.

Solution to Problem

The present inventors made a continuous diligent study in order to solve the above-described technical problem, and consequently have reached the present invention by discovering that the above-described object can be achieved by a resin composition including a polyamide having a specific melting point and a polyester having a specific structure. Specifically, the gist of the present invention is as follows.
(1) A resin composition including a polyamide (A), a polyester (B) and a white pigment (C), wherein the polyamide (A) has a melting point of 280°C or higher, the polyester (B) is polycyclohexylenedimethylene terephthalate, a mass ratio (A/B) between the polyamide (A) and the polyester (B) is 5/95 to 95/5, and a content of the white pigment (C) is 10 to 150 parts by mass in relation to 100 parts by mass of a total amount of the polyamide (A) and the polyester (B).
(2) The resin composition according to (1), further including a reinforcing material (D), wherein a content of the reinforcing material (D) is 10 to 80 parts by mass in relation to 100 parts by mass of the total amount of the polyamide (A) and the polyester (B).
(3) The resin composition according to (1) or (2) further including an antioxidant (E), wherein a content of the antioxidant (E) is 0.05 to 2.5 parts by mass in relation to 100 parts by mass of the total amount of the polyamide (A) and the polyester (B).

(4) The resin composition according to any one of (1) to (3) further including a light stabilizer (F), wherein a content of the light stabilizer (F) is 0.1 to 3 parts by mass in relation to 100 parts by mass of the total amount of the polyamide (A) and the polyester (B).

(5) The resin composition according to (3), wherein the antioxidant (E) is one or more selected from a group consisting of a phosphorus-based antioxidant, a hindered phenol antioxidant and a sulfur-based antioxidant.

(6) The resin composition according to any one of (1) to (5), wherein the polyamide (A) is a semi-aromatic polyamide including an aromatic dicarboxylic acid component, an aliphatic diamine component and a monocarboxylic acid component.

(7) The resin composition according to (6), wherein the aliphatic diamine component includes 1,10-decanediamine.

(8) The resin composition according to any one of (1) to (7), wherein the white pigment (C) is one or more selected from a group consisting of titanium oxide, barium sulfate and calcium carbonate.

(9) A reflection plate obtained by forming the resin composition according to any one of (1) to (8).

(10) An LED package including the reflection plate according to (9).

(11) An illumination device including the LED package according to (10).

Advantageous Effects of Invention

According to the present invention, it is possible to provide a resin composition constituting a reflection plate having reflow resistance and being suppressed in degradation of the reflectance even in a prolonged heating environment.

Brief Description of Drawings

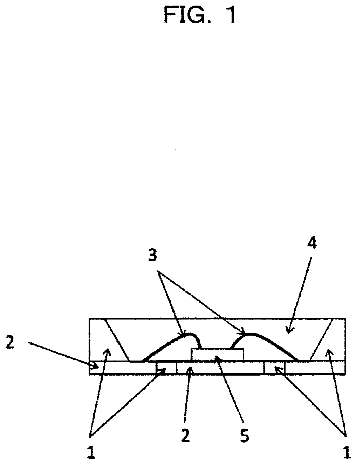

[FIG. 1] FIG. 1 is a schematic cross-sectional view showing the cross-section of a surface mounting type LED package using the resin composition of the present invention as the reflection plate in the LED package.

Description of Embodiments

The resin composition of the present invention includes a polyamide (A), a polyester (B) and a white pigment (C).

The polyamide (A) constituting the resin composition of the present invention is required to have a melting point of 280°C or higher. The constitution of the polyamide (A) is not particularly limited; examples of the polyamide (A) include: a semi-aromatic polyamide; a mixture of semi-aromatic polyamides; copolymers of semi-aromatic polyamides; and copolymers of semi-aromatic polyamides and aliphatic polyamides. Examples of the semi-aromatic polyamide include a polyamide including an aromatic dicarboxylic acid component and an aliphatic diamine component.

Examples of the aromatic dicarboxylic acid component constituting the semi-aromatic polyamide include: terephthalic acid, isophthalic acid, phthalic acid and naphthalene dicarboxylic acid; preferable among these is terephthalic acid because there is obtained a polyamide satisfactory in the balance between mold fluidity and mechanical physical properties.

In the semi-aromatic polyamide, in addition to the aromatic dicarboxylic acid component, the following dicarboxylic acid components may be copolymerized: aliphatic dicarboxylic acid components such as oxalic acid, malonic acid, succinic acid, glutaric acid, adipic acid, pimelic acid, suberic acid, azelaic acid, sebacic acid, undecanedioic acid and dodecanedioic acid; and alicyclic dicarboxylic acid components such as cyclohexane dicarboxylic acid. The content of each of these aromatic dicarboxylic acids other than terephthalic acid, these aliphatic dicarboxylic acids and these alicyclic dicarboxylic acids is preferably 5 mol% or less in relation to the total number of moles of the raw material monomers; and these dicarboxylic acids are more preferably substantially not included.

Examples of the aliphatic diamine component constituting the semi-aromatic polyamide include: 1,2-ethanediamine, 1,3-propanediamine, 1,4-butanediamine, 1,5-pentanediamine, 1,6-hexanediamine, 1,7-heptanediamine, 1,8-octanediamine, 1,9-nonandiamine, 1,10-decanediamine, 1,11-undecanediamine, 1,12-dodecanediamine, 2-methyl-1,5-pentanediamine and 2-methyl-1,8-octanediamine. Preferable among these are 1,8-octanediamine, 1,10-decanediamine and 1,12-dodecanediamine because there are obtained polyamides high in crystallinity and improved in reflectance; more preferable is 1,10-decanediamine because there are obtained polyamides satisfactory in the balance between mold fluidity and mechanical physical properties. The above-described aliphatic diamine components may be used in combinations of two or more thereof.

In the semi-aromatic polyamide, in addition to the above-described aliphatic diamine components, diamine components such as alicyclic diamine components such as cyclohexane diamine or aromatic diamine components such as xylylenediamine and benzene diamine may be copolymerized. The content of each of these alicyclic diamines and these aromatic diamines is preferably 5 mol% or less in relation to the total number of moles of the raw material monomers; and these diamines are more preferably substantially not included.

Specific examples of the polyamide (A) used in the present invention include: polyamide 10T (polymer made of decanediamine and terephthalic acid), polyamide 10I (polymer made of decanediamine and isophthalic acid), polyamide 9T(polymer made of nonanediamine and terephthalic acid), polyamide 6T (polymer made of hexanediamine and terephthalic acid), polyamide M-5T (polymer made of methylpentanediamine and terephthalic acid), polyamide 10T/10I (copolymer of polyamide 10T and polyamide 10I), polyamide 10T/9T (copolymer of polyamide 10T and polyamide 9T), polyamide 10T/6T (copolymer of polyamide 10T and polyamide 6T), polyamide 10T/66 (copolymer of polyamide 10T and polyamide 66), polyamide 10T/6 (copolymer of polyamide 10T and polyamide 6), polyamide 6T/6I (copolymer of polyamide 6T and polyamide 6I), polyamide 6T/M-5T (copolymer of polyamide 6T and polyamide M-5T), polyamide 6T/66 (copolymer of polyamide 6T and polyamide 66), polyamide 6T/6I/66 (copolymer of polyamide 6T, polyamide 6I and polyamide 66) and polyamide 6T/6 (copolymer of polyamide 6T and polyamide 6).

The semi-aromatic polyamide preferably includes a monocarboxylic acid component. The content of the monocarboxylic acid component, in relation to the whole of the monomer components constituting the semi-aromatic polyamide is preferably 4.0 mol% or less, and because of being capable of improving the mold fluidity of the polyamide, more preferably 0.3 to 4.0 mol%, furthermore preferably 0.3 to 3.0 mol% and particularly preferably 0.8 to 2.5 mol%. When the content of the monocarboxylic acid exceeds 4.0 mol%, the polyamide is sometimes low in mechanical properties.

The molecular weight of the monocarboxylic acid component is preferably 140 or more and more preferably 170 or more. When the molecular weight of the monocarboxylic acid is 140 or more, the mold fluidity of the polyamide is improved. Moreover, the obtained resin composition is improved in the fluidity during melt processing, hence allows the processing temperature to be decreased or the shear heating to be made smaller, and thus, allows a reflection plate suppressed in the reflectance degradation after heat treatment to be formed. The compatibility during melt kneading of the semi-aromatic polyamide and polycyclohexylene dimethylene terephthalate is improved, and the strength of the obtained formed article is also improved.

Examples of the monocarboxylic acid include aliphatic monocarboxylic acids, alicyclic monocarboxylic acids, and aromatic monocarboxylic acids; preferable among these are aliphatic monocarboxylic acids because of being high in the improvement effect of fluidity. Examples of the aliphatic monocarboxylic acid having a molecular weight of 140 or more include caprylic acid, nonanoic acid, decanoic acid, lauric acid, myristic acid, palmitic acid, stearic acid and behenic acid. Preferable among these is stearic acid because of being high in versatility. Examples of the alicyclic monocarboxylic acid having a molecular weight of 140 or more include 4-ethylcyclohexanecarboxylic acid, 4-hexylcyclohexanecarboxylic acid and 4-laurylcyclohexanecarboxylic acid. Examples of the aromatic monocarboxylic acid include 4-ethylbenzoic acid, 4-hexylbenzoic acid, 4-laurylbenzoic acid, alkylbenzoic acids, 1-naphthoic acid, 2-naphthoic acid and the derivatives of these. Two or more of the monocarboxylic acid components may be used in combination; for example, a monocarboxylic acid having a molecular weight of 140 or more and a monocarboxylic acid having a molecular weight of less than 140 may be used in combination. In the present invention, the molecular weight of a monocarboxylic acid means the molecular weight of the monocarboxylic acid as a raw material.

With the semi-aromatic polyamide, if necessary, lactams such as caprolactam and laurolactam, and $\alpha,\omega$-aminocarboxylic acids such as $\alpha,\omega$-aminocaproic acid, $\alpha,\omega$-aminononanoic acid and $\alpha,\omega$-aminoundecanoic acid may also be copolymerized.

The semiaromatic polyamide can be produced by using the hitherto known method such as the heating polymerization method or the solution polymerization method. Among these, the heat polymerization method is preferably used because of being industrially advantageous. Examples of the heating polymerization method include a method including a step (i) of obtaining a reactant from an aromatic dicarboxylic acid component and an aliphatic diamine component, and a step (ii) of polymerizing the obtained reactant.

Examples of the step (i) include a method in which the aromatic dicarboxylic acid powder is beforehand heated to a temperature equal to or higher than the melting point of the aliphatic diamine and equal to or lower than the melting point of the aromatic dicarboxylic acid, and the aliphatic diamine is added to the aromatic dicarboxylic acid powder at this temperature in such a way that the state of a powder of the aromatic dicarboxylic acid is maintained, substantially without allowing water to be included. Alternatively, examples of another method include a method in which a suspension composed of the aliphatic diamine in a molten state and the aromatic dicarboxylic acid in a solid state is stirred and mixed to prepare a mixed solution; then at a temperature lower than the melting point of the semi-aromatic polyamide to be finally produced, the salt production reaction based on the reaction of the aromatic dicarboxylic acid and the aliphatic diamine, and the production reaction of a lower polymer based on the polymerization of the produced salt are performed; and thus, a mixture composed of the salt and the lower polymer is obtained. In this case, the reaction mixture may be crushed while the reaction is being allowed to proceed, or alternatively, after the reaction, once the reaction mixture is taken out and then may be crushed. The step (i) is preferably the former step (i) easy in controlling the shape of the reactant.

Examples of the step (ii) include a method in which the reactant obtained in the step (i) is subjected to solid phase polymerization at a temperature lower than the melting point of the semi-aromatic polyamide to be finally produced, so as to allow the molecular weight to be increased to the predetermined molecular weight, and thus the semi-aromatic polyamide is obtained. The solid phase polymerization is preferably performed at a polymerization temperature of 180 to 270°C, with a reaction time of 0.5 to 10 hours, in a flow of an inert gas such as nitrogen.

In the production of the semi-aromatic polyamide, a polymerization catalyst may be used in order to increase the efficiency of the polymerization. Examples of the polymerization catalyst include phosphoric acid, phosphorous acid, hypophosphorous acid and the salts of these. The addition amount of the polymerization catalyst is usually preferably 2 mol% or less in relation to the total number of moles of the aromatic dicarboxylic acid and the aliphatic diamine.

In the present invention, the melting point of the polyamide (A) is required to be 280°C or higher, and is preferably 300°C or higher. When the melting point of the polyamide (A) is lower than 280°C, the obtained formed article is sometimes poor in reflow resistance.

In the present invention, the relative viscosity of the polyamide (A) as measured in 96% sulfuric acid, at 25°C and at a concentration of 1 g/dL is preferably 1.8 or more, more preferably 1.8 to 2.6 and furthermore preferably 1.9 to 2.4. The relative viscosity can be adopted as an index of the molecular weight.

The polyester (B) constituting the resin composition of the present invention is required to be polycyclohexylene dimethylene terephthalate. Polycyclohexylene dimethylene terephthalate is a polycondensate of a dicarboxylic acid component containing terephthalic acid and a glycol component containing 1,4-cyclohexanedimethanol. The content of terephthalic acid in the dicarboxylic acid component is preferably 80 mol% or more, and the content of 1,4-cyclohexanedimethanol in the glycol component is also preferably 80 mol% or more. Polycyclohexylene dimethylene terephthalate is available from SK Chemicals Co., Ltd. and Eastman Chemical Co.

In the present invention, the weight average molecular weight of the polyester (B) is preferably 40,000 to 90,000 and more preferably 55,000 to 85,000. When the weight average molecular weight of the polyester (B) is less than 40,000, the mechanical properties are sometimes poor, and when the weight average molecular weight exceeds 90,000, the fluidity during melt processing is degraded and the formability is sometimes poor. The weight average molecular weight is a value measured by gel permeation chromatography (GPC) relative to polystyrene standards, the GPC using as the solvent a chloroform/hexafluoroisopropanol (volume ratio: 95/5) solution.

In the present invention, the mass ratio (A/B) between the polyamide (A) and the polyester (B) is required to be 5/95 to 95/5, is preferably 20/80 to 80/20 and more preferably 20/80 to 50/50. When the content of the polyamide (A) is less than 5% by mass, the obtained reflection plate is low in mechanical properties, and is additionally degraded in reflectance in a heating environment and poor in reflow resistance. When the content of the polyamide (A) exceeds 95% by mass, the obtained reflection plate is similarly degraded in reflectance in a heating environment.

Examples of the white pigment (C) constituting the resin composition of the present invention include, without being particularly limited to: titanium oxide, barium sulfate and calcium carbonate; preferable among these is titanium oxide because a reflection plate having a high reflectance is obtained.

Titanium oxide preferably has a rutile type or anatase type crystal structure; titanium oxide having a rutile type crystal structure high in refractive index and satisfactory in light stability is more preferable. The particle size of titanium oxide is preferably 0.05 to 2.0 $\mu$m and more preferably 0.05 to 0.5 $\mu$m. Titanium oxide may be subjected to a surface treatment for the purpose of neutralization or improving the wettability with polymer. Examples of the surface treatment agent include: metal oxides such as alumina, silica, zinc oxide and zirconium oxide; organic acids such as stearic acid and metal salts of these; polyol; a silane coupling agent; and a titanium coupling agent.

Barium sulfate may be either a natural product or a synthetic product; examples of the former include barite and examples of the latter include precipitated barium sulfate. Barium sulfate may be subjected to a surface treatment for the purpose of neutralization or improving the wettability with polymer. The particle size of barium sulfate is preferably 0.005 to 10 $\mu$m and more preferably 0.01 to 1 $\mu$m.

Examples of calcium carbonate include calcite, aragonite, natural calcium carbonate (heavy calcium carbonate) and synthetic calcium carbonate (precipitated calcium carbonate); preferable among these are calcite and aragonite. Calcium carbonate may be subjected to a surface treatment for the purpose of neutralization or improving the wettability with polymer. The particle size of calcium carbonate is preferably 0.05 to 10 $\mu$m and more preferably 0.1 to 5 $\mu$m.

The content of the white pigment (C) is required to be 10 to 150 parts by mass, and is preferably 20 to 130 parts by mass, more preferably 20 to 100 parts by mass and furthermore preferably 30 to 100 parts by mass, in relation to 100 parts by mass of the total amount of the polyamide (A) and the polyester (B). When the content of the white pigment (C) is less than 10 parts by mass, the obtained reflection plate has a low reflectance. On the other hand, when the content of the white pigment (C) exceeds 150 parts by mass, the reinforcing efficiency of the mechanical properties is degraded, and additionally, the workability during melt kneading is degraded to make it difficult to obtain a pellet of the resin composition.

The resin composition of the present invention may include a reinforcing material (D). Examples of the reinforcing material (D) include: glass fiber, potassium titanate fiber, alumina fiber, silica fiber, zirconia fiber, silicon carbide fiber, ceramic fiber, wollastonite, sepiolite, attapulgite, zinc oxide, zinc sulfide, zinc sulfate, barium sulfate, calcium carbonate and aluminum oxide. Preferable among these are zinc oxide, zinc sulfide, zinc sulfate, barium sulfate, calcium carbonate and aluminum oxide, because of being not melted at the melting temperature of the resin composition and maintaining or improving the reflectance. Glass fiber, potassium titanate fiber and wollastonite are also preferable, because of improving the mechanical properties.

Glass fiber as a reinforcing material (D) is preferably surface treated with a silane coupling agent; the surface treatment may also be performed by dispersing the silane coupling agent in a sizing gent for bundling glass fibers. Examples of the silane coupling agent include: a vinylsilane-based silane coupling agent, an acrylic silane-based silane coupling agent, an epoxysilane-based silane coupling agent and an aminosilane-based silane coupling agent; preferable among these is the aminosilane-based silane coupling agent, because the adhesion effect between the polyamide (A) and glass fiber is easily obtained.

The fiber length of the glass fiber is preferably 0.01 to 7 mm and more preferably 0.02 to 5 mm. The fiber diameter is preferably 1 to 20 $\mu$m and more preferably 3 to 12 $\mu$m. Under the conditions that the fiber length falls within a range from 0.01 to 7 mm and the fiber diameter falls within a range from 1 to 20 $\mu$m, the glass fiber allows the resin composition to be reinforced efficiently without adversely affecting the formability.

When the resin composition includes the reinforcing material (D), the content of the reinforcing material (D) is preferably 10 to 80 parts by mass, more preferably 15 to 60 parts by mass and furthermore preferably 20 to 40 parts by mass, in relation to 100 parts by mass of the total amount of the polyamide (A) and the polyester (B). When the content of the reinforcing material (D) is less than 10 parts by mass, the improvement effect of the mechanical properties is sometimes not obtained; on the other hand, when the content of the reinforcing material (D) exceeds 80 parts by mass, sometimes the reinforcing efficiency of the mechanical properties is degraded or the workability during melt kneading is degraded to make it difficult to obtain a pellet of the resin composition; or alternatively, the reinforcing material comes up to the surface and accordingly the reflectance of the obtained reflection plate is sometimes degraded.

The resin composition of the present invention may include an antioxidant (E) for the purpose of suppressing the degradation of the reflectance.

A resin composition including a fibrous reinforcing material as the reinforcing agent (D) sometimes causes the degradation of the mechanical properties, due to the thermal decomposition of the surface treatment agent of the fibrous reinforcing material in the case where the resin composition is retained in the high-temperature cylinder for a long period of time when the forming cycle is long or the injection amount is small in injection molding. However, by including the antioxidant (E), the degradation of the mechanical properties of the resin composition can be suppressed. The antioxidant (E) is usually included for the purpose of decreasing the molecular weight of the resin composition or degrading the color of the resin composition; however, as described above, the retention stability of the resin composition can be improved.

When the resin composition includes the antioxidant (E), the content of the antioxidant (E) is preferably 0.05 to 2.5 parts by mass and more preferably 0.5 to 2.5 parts by mass, in relation to 100 parts by mass of the total amount of the polyamide (A) and the polyester (B). When the content of the antioxidant (E) is less than 0.05 parts by mass, the above-described effect is sometimes small; on the other hand, when the content of the antioxidant (E) exceeds 2.5 parts by mass, the mold tends to be contaminated by the decomposition product, and the molding failure is sometimes caused.

Examples of the antioxidant (E) include: phosphorus-based antioxidants, hindered phenol antioxidants, hindered amine antioxidants, triazine-based compounds and sulfur-based compounds; in particular, preferable among these are the phosphorus-based antioxidants, the hindered phenol antioxidants and the sulfur-based compounds.

The phosphorus-based antioxidant may be either an inorganic compound or an organic compound. Examples of the phosphorus-based antioxidant include: inorganic phosphoric acid salts such as monosodium phosphate, disodium phosphate, trisodium phosphate, sodium phosphite, calcium phosphite, magnesium phosphite and manganese phosphite; and triphenyl phosphite, trioctadecyl phosphite, tridecyl phosphite, trinonylphenyl phosphite, diphenyl isodecyl phosphite, bis(2,6-di-tert-butyl-4-methylphenyl)pentaerythritol diphosphite, tris(2,4-di-tert-butylphenyl) phosphite, distearyl pentaerythritol diphosphite, bis(nonylphenyl)pentaerythritol diphosphite and tetrakis(2,4-di-t-butylphenyl)-4,4'-biphenylene diphosphonite. These phosphorus-based antioxidants may be used each alone or in combinations of two or more thereof. Preferable among these are bis(2,6-di-tert-butyl-4-methylphenyl)pentaerythritol diphosphite and tetrakis(2,4-di-t-butylphenyl)-4,4'-biphenylene diphosphonite. Examples of the commercially available phosphorus-based antioxidant include: "Adeka Stab" PEP-8, PEP-36 and PEP-4C manufactured by Adeka Corp.; and "Hostanox" P-EPQ manufactured by Clariant Japan K.K.

Examples of the hindered phenol antioxidant include: n-octadecyl-3-(3',5'-di-t-butyl-4'-hydroxyphenyl)-propionate, n-octadecyl-3-(3'-methyl-5'-t-butyl-4'-hydroxyphenyl)-propionate, n-tetradecyl-3-(3',5'-di-t-butyl-4'-hydroxyphenyl)-propionate, 1,6-hexanediol-bis-[3-(3,5-di-t-butyl-4-hydroxyphenyl)-propionate], 1,4-butanediol-bis-[3-(3,5-di-t-butyl-4-hydroxyphenyl)-propionate], 2,2'-methylenebis-(4-methyl-t-butylphenol), triethylene glycol-bis-[3-(3-t-butyl-5-methyl-4-hydroxyphenyl)-propionate], tetrakis[methylene-3-(3',5'-di-t-butyl-4'-hydroxyphenyl)propionate]methane, 3,9-bis [2-{3-(3-t-butyl-4-hydroxy-5-methylphenyl)propionyloxy}-1,1-dimethylethyl]-2,4,8,10-tetraoxaspiro(5.5)undecane, N,N'-bis-3-(3',5'-di-t-butyl-4'-hydroxyphenyl)propionylhexamethylenediamine, N,N'-tetramethylene-bis -3-(3'-methyl-5'-t-butyl-4'-hydroxyphenol)propionyldiamine, N,N'-bis-[3-(3,5-di-t-butyl-4-hydroxyphenol)propionyl]hydrazine, N-salicyloyl-N'-salicylidenehydrazine, 3-(N-salicyloyl)amino-1,2,4-triazole, N,N'-bis[2-{3-(3,5-di-t-butyl-4-hydroxyphenyl)propionyloxy}ethyl]oxamide, pentaerythrityl-tetrakis[3-(3,5-di-t-butyl-4-hydroxyphenyl)propionate] and N,N'-hexamethylenebis-(3,5-di-t-butyl-4-hydroxy-hydrocinnamide). These hindered phenol antioxidants may be used each alone or in combinations of two or more thereof. Preferable among these are triethylene glycol-bis-[3-(3-t-butyl-5-methyl-4-hydroxyphenyl)-propionate], tetrakis[methylene-3-(3',5'-di-t-butyl-4'-hydroxyphenyl)propionate]methane, 1,6-hexanediolbis-[3-(3,5-di-t-butyl-4-hydroxyphenyl)-propionate], pentaerythrityl-tetrakis[3-(3,5-di-t-butyl-4-hydroxyphenyl)propionate] and N,N'-hexamethylenebis-(3,5-di-t-butyl-4-hydroxy-hydrocinnamide). Examples of the commercially available hindered phenol antioxidant include: "Adeka Stab" AO-20, AO-30, AO-40, AO-50, AO-60, AO-70, AO-80 and AO-330 manufactured by Adeka Corp.; "Irganox" 245, 259, 565, 1010, 1035, 1076, 1098, 1222, 1330, 1425, 1520, 3114 and 5057 manufactured by Ciba Specialty Chemicals Inc.; "Sumilizer" BHT-R, MDP-S, BBM-S, WX-R, NW, BP-76, BP-101, GA-80, GM and GS manufactured by Sumitomo Chemical Industry Co., Ltd.; and "Cyanox" CY-1790 manufactured by Cyanamide Co.

Examples of the sulfur-based antioxidant include: distearyl 3,3'-thiodipropionate, pentaerythrityl tetrakis(3-laurylthiopropionate), 2-mercaptobenzimidazole, didodecyl 3,3'-thiodipropionate, dioctadecyl 3,3'-thiodipropionate, ditridecyl 3,4'-thiodipropionate and 2,2-bis[[3-(dodecylthio)-1-oxopropoxy]methyl]-1,3-propanediyl ester. These sulfur-based antioxidants may be used each alone or in combinations of two or more thereof. Preferable among these are distearyl 3,3'-thiodipropionate and pentaerythrityl tetrakis(3-laurylthiopropionate). Examples of the commercially available sulfur-based antioxidant include: "Sumilizer" TP-D manufactured by Sumitomo Chemical Industry Co., Ltd.

The resin composition of the present invention may include a light stabilizer (F), for the purpose of suppressing the degradation of the reflectance. Because in the resin composition including titanium oxide as the white pigment (C), titanium oxide sometimes promotes photolysis, such a resin composition preferably includes the light stabilizer (F).

When the light stabilizer (F) is included, the content of the light stabilizer (F) is preferably 0.1 to 3 parts by mass and more preferably 0.2 to 2 parts by mass, in relation to 100 parts by mass of the total amount of the polyamide (A) and the polyester (B). When the content of the light stabilizer (F) is less than 0.1 part by mass, the obtained reflection plate is sometimes small in the suppression effect of the degradation of the reflectance; when the content of the light stabilizer (F) exceeds 3 parts by mass, the mold tends to be contaminated by the decomposition product, and the molding failure is sometimes caused.

Examples of the light stabilizer (F) include: benzophenone-based compounds, benzotriazole-based compounds, salicylate-based compounds, hindered amine-based compounds (HALS) and hindered phenolic compounds; preferable among these are hindered amine-based compounds because of being high in the affinity with semi-aromatic polyamide or in reflow resistance. Examples of the commercially available light stabilizer include: "Nylostab" S-EED manufactured by Clariant Japan K.K., "Biosorb" 04 manufactured by Kyodo Chemical Co., Ltd., "Tinuvin" 622 and 765 manufactured by Ciba Specialty Chemicals Inc., "Cyasorb "UV-3346 manufactured by Cytec Inc., "Adeka Stab" LA-57 manufactured by Asahi Denka Kogyo Co., Ltd., and "Chimassorb" 119 and 944 manufactured by BASF Inc.

In the present invention, it is preferable to use the antioxidant (E) and the light stabilizer (F) in combination. By using the antioxidant (E) and the light stabilizer (F) in combination, the retention stability of the resin composition can be improved during forming, and the obtained reflection plate is efficiently prevented from the thermal degradation at high temperatures, and can be suppressed in the degradation of the reflectance.

The resin composition of the present invention preferably further includes metal hydroxides such as aluminum hydroxide, magnesium hydroxide and calcium hydroxide. By including the metal hydroxide, in the obtained reflection plate, the degradation of the reflectance can be efficiently suppressed. The metal hydroxides may be subjected to a surface treatment for the purpose of neutralization or improving the wettability with polymer. When the metal hydroxide is included, the content of the metal hydroxide is preferably 0.1 to 30 parts by mass and more preferably 1 to 20 parts by mass, in relation to 100 parts by mass of the total amount of the polyamide (A) and the polyester (B).

To the resin composition of the present invention, other additives may also be added if necessary. Examples of the other additives include: fillers such as talc, swelling clay minerals, silica and glass beads; antistatic agent; flame retardants; and flame retardant aids.

Examples of the method for producing the resin composition of the present invention include, without being particularly limited to: a method in which the polyester (B) and the white pigment (C) are added during the polymerization of the polyamide; and a method in which the polyamide (A), the polyester (B) and the white pigment (C) are melt kneaded; during the melt kneading, the reinforcing material (D), the antioxidant (E), the light stabilizer (F), and other additives may also be added if necessary.

By forming the resin composition of the present invention, the formed articles such as the reflection plate of the present invention can be produced. Examples of the forming method include an injection molding method, an extrusion molding method and a blow molding method; preferable among these is the injection molding method.

Examples of the injection molding machine include, without being particularly limited to: a screw in-line type injection molding machine and a plunger type injection molding machine. The resin composition heat-melted in the cylinder of the injection molding machine is metered every shot, injected into a mold in a molten state, cooled and solidified in a predetermined shape, and then taken out as a formed article from the mold. The resin temperature at the time of injection molding is preferably equal to or higher than the melting point of the resin composition and more preferably lower than (the melting point + 100°C). It is preferable to use the sufficiently dried resin composition at the time of the heat melting of the resin composition. When the resin composition is high in water content, the resin composition undergoes foaming in the cylinder of an injection molding machine, and sometimes it comes to be difficult to obtain an optimal formed article. The water content of the resin composition to be used for injection molding is preferably less than 0.3% by mass and more preferably less than 0.1% by mass.

The reflection plate of the present invention has reflow resistance and is suppressed in the degradation of the reflectance even in a prolonged heating environment, and hence can be used as the reflection plate for an LED package, the LED package can be used in an LED illumination device.

The formed article obtained by forming the resin composition of the present invention can also be used in a wide range of applications such as the applications to automobile components and electric/electronic components. Examples of the automobile components include: electrical components such as lamp reflectors, lamp housings, lamp extensions and lamp sockets. Examples of the electric/electronic components include: connectors, switches, sensors, capacitors, jacks, relays, coil bobbins, resistors and various enclosures.

Examples

Hereinafter, the present invention is described specifically by way of Examples. However, the present invention is not limited by these Examples.

1. Measurement Methods

(1) Relative Viscosity of Polyamide

The relative viscosity was measured by using sulfuric acid having a concentration of 96% by mass as a solvent, at a concentration of 1 g/dL and at 25°C.

(2) Melting Point of Polyamide

By using a differential scanning calorimeter DSC-7 manufactured by Perkin-Elmer Corp., a polyamide sample was increased in temperature to 350°C at a temperature increase rate of 20°C/min, then maintained at 350°C for 5 minutes, decreased in temperature to 25°C at a temperature decrease rate of 20°C/min, further maintained at 25°C for 5 minutes, and then again increased in temperature at a temperature increase rate of 20°C/min; and the endothermic peak top temperature in this temperature increase measurement was taken as the melting point of the polyamide.

(3) Tensile Strength

The resin composition was sufficiently dried, and then a specimen according to ISO was prepared, by using an injection molding machine ($\alpha$-100iA) manufactured by Fanuc Corp., under the conditions of a resin temperature of 330°C, a mold temperature of 135°C and a forming cycle of 25 seconds. The tensile strength of the obtained specimen was measured according to ISO527.

Practically, the tensile strength is preferably 35 MPa or more.

(4) Reflectance and Reflectance Retention Rate

The resin composition was sufficiently dried, and then a 20 mm × 20 mm × 0.5 mm formed article was prepared, by using an injection molding machine (CND-15AII) manufactured by Niigata Machine Techno Co., Ltd., under the conditions of a resin temperature of 330°C, a mold temperature of 135°C and a forming cycle of 15 seconds.

The obtained formed article was heat treated at 150°C for 300 hours in an oven; for each of the formed article before the heat treatment and the formed article after the heat treatment, the reflectance at a wavelength of 460 nm was measured with the spectrophotometer SE6000 (light source: C-2) manufactured by Nippon Denshoku Industries Co., Ltd.

Practically, the reflectance before the treatment is preferably 90% or more and more preferably 95% or more.

The reflectance retention rate was obtained by using the following formula:

```
Reflectance retention rate = ([reflectance after
treatment]/[reflectance before treatment]) × 100
```

**EP 3 162 856 A1**

The reflectance retention rate is preferably 90% or more and more preferably 95% or more.

(5) Reflow Resistance

On a lead frame set in a mold, the resin composition was injection-molded to prepare a reflection plate, and successively, a blue LED element made of an InGaN blue LED was fixed as a semiconductor light emitting element on the reflection plate by using a silver paste. Gold wires were arranged, then a transparent sealing resin was injected, and heated at 150°C, for 1 hour to be cured, and thus, a surface mounting type LED package shown in FIG. 1 was obtained. In FIG. 1, the reference numerals 1, 2, 3, 4 and 5 denote a reflection plate, a lead frame, a gold wire, a transparent sealing resin and a semiconductor light-emitting element, respectively.

Twenty of the obtained surface mounting type LED packages were subjected to the JEDEC (Joint Electron Device Engineering Councils) level 3 moisture absorption treatment (treated for 50 hours under the environmental conditions of a temperature at 60°C and a humidity of 60%), and then the reflow test under the temperature conditions of a peak temperature of 260°C and a duration of 10 seconds, according to JEDECJ-STD-020D was repeated twice. After the reflow test, the reflection plate 1 and the transparent sealing resin 4 in each of the LED packages were observed with a stereoscopic microscope, and the LED packages were evaluated on the basis of the following standards.

Defective product: Discoloration or cracks occur in the reflection plate 1, or detachment occurs between the reflection plate 1 and the transparent sealing resin 4.

Good product: Neither discoloration nor cracking occurs in the reflection plate 1, and no detachment occurs between the reflection plate 1 and the transparent sealing resin 4.

The defective product rate after reflow test (=(number of defective product/number of packages used in test) $\times$ 100(%)) was calculated; the rates of 95% or more, less than 95% and 90% or more, and less than 90% were marked with E(Excellent), G(Good) and P(Poor), respectively.

2. Starting Materials

(1) Polyamide (A)

• Semi-aromatic polyamide (A-1)

In a ribbon blender type reactor, 4.70 kg of terephthalic acid (TPA) in powder form as an aromatic dicarboxylic acid component, 0.32 kg of stearic acid (STA) as an monocarboxylic acid component, and 9.3 g of sodium hypophosphite monohydrate as a polymerization catalyst were placed, and the resulting mixture was heated while being stirred at a number of rotations of 30 rpm to 170°C under sealing with nitrogen. Subsequently, while the temperature was being maintained at 170°C and the number of rotations was also being maintained at 30 rpm, by using a liquid injection apparatus, 4.98 kg of 1,10-decanediamine (DDA) heated to 100°C was continuously (continuous liquid injection procedure) added over 2.5 hours as an aliphatic diamine component to yield a reactant. The molar ratio between the starting material monomers was TPA:DDA:STA = 48.5:49.6:1.9 (equivalent ratio between functional groups of starting material monomers was TPA:DDA:STA = 49.0:50.0:1.0).

Successively, the obtained reactant was polymerized in the same reactor in a nitrogen gas flow by heating at 250°C at a number of rotations of 30 rpm for 8 hours, to prepare a semi-aromatic polyamide powder.

Subsequently, the obtained semi-aromatic polyamide powder was converted into a strand shape by using a twin screw kneader, the strands were allowed to pass through a water tank to be cooled and solidified, and the solidified product was cut with a pelletizer to yield a semi-aromatic polyamide (A-1) pellet.

• Semi-Aromatic Polyamides (A-2 to A-8)

Semi-aromatic polyamide pellets (A-2 to A-8) were obtained in the same manner as in the case of the semi-aromatic polyamide (A-1) except that the types and mixing amounts of the individual components were altered so as to give the resin compositions shown in Table 1. The molecular weights of the monocarboxylic acids used are as follows: stearic acid: 284, caprylic acid: 144 and benzoic acid: 122.

Table 1 shows the compositions, melting points and relative viscosities of the semi-aromatic polyamides (A-1 to A-8).

9

[Table 1]

| | | Resin composition of semi-aromatic polyamide | | | | | | | Values of properties | |
| --- | --- | --- | --- | --- | --- | --- | --- | --- | --- | --- |
| | | Aromatic dicarboxylic acid component | | Aliphatic diamine component | | Monocarboxylic acid component | | | Melting point | Relative viscosity |
| | | Type | Content | Type | Content | Type | Molecular weight | Content | | |
| | | | mol% | | mol% | | | mol% | °C | |
| A-1 | | TPA | 48.5 | DDA | 49.6 | STA | 284 | 1.9 | 317 | 2.30 |
| A-2 | | TPA | 49.3 | DDA | 50.4 | STA | 284 | 0.3 | 317 | 3.50 |
| A-3 | | TPA | 47.0 | DDA | 49.4 | STA | 284 | 3.6 | 310 | 1.85 |
| A-4 | | TPA | 48.5 | DDA | 49.6 | BA | 122 | 1.9 | 317 | 2.24 |
| A-5 | | TPA | 48.5 | NDA | 49.6 | STA | 284 | 1.9 | 310 | 2.18 |
| A-6 | | TPA | 48.5 | DDA | 49.6 | CP | 144 | 1.9 | 317 | 2.25 |
| A-7 | | TPA | 48.5 | DDA HDA | 34.7 14.9 | STA | 284 | 1.9 | 295 | 2.16 |
| A-8 | | TPA IPA | 38.3 10.2 | DDA | 49.6 | STA | 284 | 1.9 | 290 | 2.26 |
| TPA: Terephthalic acid, IPA: Isophthalic acid, DDA: 1,10-Decanediamine, NDA: 1,9-Nonanediamine, HDA: 1,6-Hexanediamine STA: Stearic acid, BA: Benzoic acid, CP: Caprylic acid | | | | | | | | | | |

- PA6T/66: "Arlen C3000" manufactured by Mitsui Chemicals, Inc., copolymer of nylon 6T and nylon 66, melting point: 310°C
- PA66: "A125" manufactured by Unitika Ltd., nylon 66, melting point: 265°C
- MXD6: "Reny 6002" manufactured by Mitsubishi Engineering-Plastics Corp., semi-aromatic polyamide composed of meta-xylenediamine and adipic acid, melting point: 243°C

(2) Polyester (B)

- PCT: polycyclohexylene dimethylene terephthalate, manufactured by SK Chemicals Co., Ltd., weight average molecular weight: 80,000

(3) Polybutylene terephthalate

- PBT: "Novaduran 5010R5" manufactured by Mitsubishi Chemical Corp.

(4) White pigment (C)

- TI:"Tipaque PC-3" manufactured by Ishihara Sangyo Kaisha, Ltd., titanium oxide, average particle size: 0.21 μm
- BS: "Barifine BF-20" manufactured by Sakai Chemical Industry Co., Ltd., barium sulfate, average particle size: 0.03 μm
- CC: "Brilliant-1500" manufactured by Shiraishi Kogyo Kaisha, Ltd., calcium carbonate, average particle size: 0.20 μm

(5) Reinforcing material (D)

- GF: "ECS03T-786H" manufactured by Nippon Electric Glass Co., Ltd., glass fiber, average fiber diameter: 10.5 μm, average fiber length: 3 mm
- W: "NYGLOS 4W" manufactured by NYCO Minerals, Inc., wollastonite, average fiber diameter: 4 μm, average fiber length: 32 μm

(6) Antioxidant (E)

- AO-1: "Adeka Stab PEP-36" manufactured by Adeka Corp., bis(2,6-di-tert-butyl-4-methylphenyl)pentaerythritol diphosphite, phosphorus-based antioxidant
- AO-2: "AO-80" manufactured by Adeka Corp., 3,9-bis[2-{3-(3-t-butyl-4-hydroxy-5-methylphenyl)propionyloxy}-1,1-dimethylethyl]-2,4,8,10-tetraoxaspiro(5.5)undecane, hindered phenol antioxidant
- AO-3: manufactured by "Sumilizer TP-D" manufactured by Sumitomo Chemical Industry Co., Ltd., pentaerythrityl tetrakis(3-laurylthiopropionate), sulfur-based antioxidant

(7) Light stabilizer (F)

- LS: "Nylostab S-EED" manufactured by Clariant Japan K.K., 2-ethyl-2'-ethoxy-oxalanilide

Example 1

To the main feeding opening of a same direction twin screw extruder (TEM26SS, screw diameter: 26 mm, L/D49, manufactured by Toshiba Machine Co., Ltd.), 95 parts by mass of the semi-aromatic polyamide (A-1), 5 parts by mass of PCT and 70 parts by mass of TI were fed, under metering by using the loss-in-weight type continuous metering feeder CE-W-1 manufactured by Kubota Corp., and were melt-kneaded. The melt temperature was 320 to 340°C, the number of rotations of the screw was 250 rpm, and the discharge rate was 35 kg/hour. Next, the molten resin composition was taken out in a strand shape, and then allowed to pass through a water tank to be cooled and solidified; the solidified product was cut with a pelletizer to yield a resin composition.

Examples 2 to 30 and Comparative Examples 1 to 7

Resin compositions were obtained in the same manner as in Example 1 except that the individual components were altered so as to give the types and the contents shown in Table 2 and Table 3. When a glass fiber or wollastonite is mixed, the glass fiber or wollastonite was fed through a side feeder from midway along the extruder and others were fed from the main feeding opening. In Comparative Example 5, polybutylene terephthalate (PBT) was used in place of the polyamide (A). In Comparative Example 6, polybutylene terephthalate (PBT) was used in place of polycyclohexylene dimethylene terephthalate.

Comparative Example 8

The same operations as in Example 11 were performed, but the content of the white pigment was high, and accordingly, the strands were broken and no resin composition was able to be obtained.
Tables 2 and 3 show the compositions and the values of the properties of the resin compositions obtained in Examples and Comparative Examples.

[Table 2]

| | | Composition of resin composition (parts by mass) | | | | | | | | | | | Values of properties | | | | |
|---|---|---|---|---|---|---|---|---|---|---|---|---|---|---|---|---|---|---|
| | | Polyamide (A) | | Polyester (B) | | White pigment (C) | | Reinforcing material (D) | | Antioxidant (E) | | | Light stabilizer (F) | Tensile strength | Reflectance | | | Reflow resistance |
| | | | | | | | | | | | | | | | Before treatment | After treatment | Retention rate | |
| | | Type | | PCT | PBT | Type | | GF | W | AO-1 | AO-2 | AO-3 | LS | MPa | % | % | % | |
| Examples | 1 | A-1 | 95 | 5 | - | TI | 70 | - | - | - | - | - | - | 68 | 95 | 86 | 91 | E |
| | 2 | A-1 | 75 | 25 | - | TI | 70 | - | - | - | - | - | - | 59 | 96 | 87 | 91 | E |
| | 3 | A-1 | 50 | 50 | - | TI | 70 | - | - | - | - | - | - | 48 | 97 | 89 | 92 | E |
| | 4 | A-1 | 25 | 75 | - | TI | 70 | - | - | - | - | - | - | 43 | 97 | 90 | 93 | E |
| | 5 | A-1 | 5 | 95 | - | TI | 70 | - | - | - | - | - | - | 38 | 94 | 86 | 91 | E |
| | 6 | A-1 | 25 | 75 | - | TI | 10 | - | - | - | - | - | - | 50 | 90 | 81 | 90 | E |
| | 7 | A-1 | 25 | 75 | - | TI | 15 | - | - | - | - | - | - | 49 | 90 | 82 | 91 | E |
| | 8 | A-1 | 25 | 75 | - | TI | 30 | - | - | - | - | - | - | 47 | 93 | 85 | 91 | E |
| | 9 | A-1 | 25 | 75 | - | TI | 100 | - | - | - | - | - | - | 42 | 97 | 92 | 95 | E |
| | 10 | A-1 | 25 | 75 | - | TI | 145 | - | - | - | - | - | - | 40 | 98 | 93 | 95 | E |
| | 11 | A-1 | 25 | 75 | - | TI | 150 | - | - | - | - | - | - | 39 | 98 | 94 | 96 | E |
| | 12 | A-1 | 25 | 75 | - | TI | 70 | 30 | - | - | - | - | - | 78 | 96 | 88 | 92 | E |
| | 13 | A-1 | 25 | 75 | - | TI | 70 | 80 | - | - | - | - | - | 112 | 95 | 88 | 93 | E |
| | 14 | A-1 | 25 | 75 | - | TI | 70 | 30 | 30 | - | - | - | - | 87 | 96 | 90 | 94 | E |
| | 15 | A-1 | 25 | 75 | - | TI | 70 | - | 50 | - | - | - | - | 61 | 97 | 90 | 93 | E |
| | 16 | A-1 | 25 | 75 | - | TI | 70 | - | - | 0.5 | - | - | - | 43 | 97 | 92 | 95 | E |
| | 17 | A-1 | 25 | 75 | - | TI | 70 | - | - | - | 1.0 | - | - | 43 | 97 | 92 | 95 | E |
| | 18 | A-1 | 25 | 75 | - | TI | 70 | - | - | - | - | 1.0 | - | 44 | 97 | 93 | 96 | E |
| | 19 | A-1 | 25 | 75 | - | TI | 70 | - | - | - | 1.0 | 1.0 | - | 42 | 97 | 93 | 96 | E |

[Table 3]

| | | Composition of resin composition (parts by mass) | | | | | | | | | | | Values of properties | | | | |
|---|---|---|---|---|---|---|---|---|---|---|---|---|---|---|---|---|---|---|
| | | Polyamide (A) | | Polyester (B) | | White pigment (C) | | Reinforcing material (D) | | Antioxidant (E) | | | Light stabilizer (F) | Tensile strength | Reflectance | | | Reflow resistance |
| | | | | | | | | | | | | | | | Before treatment | After treatment | Retention rate | |
| | | Type | | PCT | PBT | Type | | GF | W | AO-1 | AO-2 | AO-3 | LS | MPa | % | % | % | |
| Examples | 20 | A-1 | 25 | 75 | - | TI | 70 | - | 50 | 0.5 | 1.0 | 1.0 | 1.0 | 62 | 97 | 95 | 98 | E |
| | 21 | A-2 | 25 | 75 | - | TI | 70 | - | 50 | 0.5 | 1.0 | 1.0 | 1.0 | 61 | 97 | 95 | 98 | E |
| | 22 | A-3 | 25 | 75 | - | TI | 70 | - | 50 | 0.5 | 1.0 | 1.0 | 1.0 | 63 | 97 | 94 | 97 | E |
| | 23 | A-4 | 25 | 75 | - | TI | 70 | - | 50 | 0.5 | 1.0 | 1.0 | 1.0 | 56 | 96 | 91 | 95 | E |
| | 24 | A-5 | 25 | 75 | - | TI | 70 | - | 50 | 0.5 | 1.0 | 1.0 | 1.0 | 63 | 96 | 92 | 96 | E |
| | 25 | A-6 | 25 | 75 | - | TI | 70 | - | 50 | 0.5 | 1.0 | 1.0 | 1.0 | 63 | 95 | 89 | 94 | E |
| | 26 | A-7 | 25 | 75 | - | TI | 70 | - | 50 | 0.5 | 1.0 | 1.0 | 1.0 | 58 | 96 | 90 | 94 | E |
| | 27 | A-8 | 25 | 75 | - | TI | 70 | - | 50 | 0.5 | 1.0 | 1.0 | 1.0 | 54 | 95 | 88 | 93 | E |
| | 28 | PA6T /66 | 25 | 75 | - | TI | 70 | - | 50 | 0.5 | 1.0 | 1.0 | 1.0 | 72 | 94 | 85 | 90 | E |
| | 29 | A-1 | 25 | 75 | - | BS | 70 | - | 50 | 0.5 | 1.0 | 1.0 | 1.0 | 47 | 90 | 84 | 93 | G |
| | 30 | A-1 | 25 | 75 | - | CC | 70 | - | 50 | 0.5 | 1.0 | 1.0 | 1.0 | 48 | 90 | 83 | 92 | G |
| Comparative Examples | 1 | A-1 | 100 | - | - | TI | 70 | - | - | - | - | - | - | 69 | 93 | 75 | 81 | E |
| | 2 | - | - | 100 | - | TI | 70 | - | - | - | - | - | - | 34 | 90 | 78 | 87 | P |
| | 3 | PA66 | 25 | 75 | - | TI | 70 | - | - | - | - | - | - | 65 | 88 | 62 | 70 | P |
| | 4 | MXD6 | 25 | 75 | - | TI | 70 | - | - | - | - | - | - | 63 | 89 | 64 | 72 | P |
| | 5 | PBT | 80 | 20 | - | TI | 80 | 20 | - | - | - | - | - | 68 | 88 | 72 | 82 | P |
| | 6 | A-1 | 25 | - | 75 | TI | 70 | - | - | - | - | - | - | 52 | 89 | 68 | 76 | P |
| | 7 | A-1 | 25 | 75 | - | TI | 5 | - | - | - | - | - | - | 51 | 80 | 63 | 79 | P |
| | 8 | A-1 | 25 | 75 | - | TI | 160 | - | - | - | - | - | - | - | - | - | - | - |

In each of Examples 1 to 30, the obtained LED package had reflow resistance, and the formed article was high in reflectance, and high in the retention rate of the reflectance in a heating environment.

In each of Examples 16 to 19, the antioxidant was included, and accordingly, the retention rate of the reflectance in a heating environment was slightly higher as compared with Example 4 including no antioxidant. In Example 20, titanium oxide was included as the white pigment, and accordingly the reflectance was slightly higher as compared with Examples 29 and 30 including other white pigments.

In Comparative Example 1, the polyamide having a high melting point was included, and accordingly the obtained LED package had reflow resistance; however, polycyclohexylene dimethylene terephthalate was not included, and accordingly, the formed article was low in the retention rate of the reflectance in a heating environment.

In Comparative Example 2, because of including no polyamide, in Comparative Examples 3 and 4, because of being low in the melting point of the polyamide, in Comparative Example 5, because of using polybutylene terephthalate in place of the polyamide, and in Comparative Example 6, because of using polybutylene terephthalate in place of polycyclohexylene dimethylene terephthalate, the obtained formed articles were low in the retention rate of the reflectance in a heating environment, and the LED packages did not have reflow resistance.

In Comparative Example 7, because the content of the white pigment was small, the obtained formed article was low in reflectance, and in the LED package shown in FIG. 1, the discoloration of the reflection plate 1 was remarkable, and the reflection plate did not have reflow resistance. In Comparative Example 8, because the content of the white pigment was high, the strand was broken and thus, no resin composition was obtained.

Reference Signs List

1    reflection plate
2    lead frame
3    gold wire
4    transparent sealing resin
5    semiconductor light-emitting element

**Claims**

1. A resin composition comprising a polyamide (A), a polyester (B) and a white pigment (C),
   wherein the polyamide (A) has a melting point of 280°C or higher;
   the polyester (B) is polycyclohexylenedimethylene terephthalate;
   a mass ratio (A/B) between the polyamide (A) and the polyester (B) is 5/95 to 95/5; and
   a content of the white pigment (C) is 10 to 150 parts by mass in relation to 100 parts by mass of a total amount of the polyamide (A) and the polyester (B).

2. The resin composition according to claim 1, further comprising a reinforcing material (D), wherein a content of the reinforcing material (D) is 10 to 80 parts by mass in relation to 100 parts by mass of the total amount of the polyamide (A) and the polyester (B).

3. The resin composition according to claim 1 or 2, further comprising an antioxidant (E), wherein a content of the antioxidant (E) is 0.05 to 2.5 parts by mass in relation to 100 parts by mass of the total amount of the polyamide (A) and the polyester (B).

4. The resin composition according to any one of claims 1 to 3, further comprising a light stabilizer (F), wherein a content of the light stabilizer (F) is 0.1 to 3 parts by mass in relation to 100 parts by mass of the total amount of the polyamide (A) and the polyester (B).

5. The resin composition according to claim 3, wherein the antioxidant (E) is one or more selected from a group consisting of a phosphorus-based antioxidant, a hindered phenol antioxidant and a sulfur-based antioxidant.

6. The resin composition according to any one of claims 1 to 5, wherein the polyamide (A) is a semi-aromatic polyamide including an aromatic dicarboxylic acid component, an aliphatic diamine component and a monocarboxylic acid component.

**7.** The resin composition according to claim 6, wherein the aliphatic diamine component includes 1,10-decanediamine.

**8.** The resin composition according to any one of claims 1 to 7, wherein the white pigment (C) is one or more selected from a group consisting of titanium oxide, barium sulfate and calcium carbonate.

**9.** A reflection plate obtained by forming the resin composition according to any one of claims 1 to 8.

**10.** An LED package comprising the reflection plate according to claim 9.

**11.** An illumination device comprising the LED package according to claim 10.

FIG. 1

## INTERNATIONAL SEARCH REPORT

| International application No. |
| --- |
| PCT/JP2015/067996 |

### A. CLASSIFICATION OF SUBJECT MATTER

$C08L77/06$(2006.01)i, $C08K3/00$(2006.01)i, $C08L67/02$(2006.01)i, $G02B1/04$(2006.01)i, $G02B5/08$(2006.01)i, $H01L33/60$(2010.01)i

According to International Patent Classification (IPC) or to both national classification and IPC

### B. FIELDS SEARCHED

Minimum documentation searched (classification system followed by classification symbols)
C08L77, C08K3, C08L67, G02B1/04, G02B5/08, H01L33/60

Documentation searched other than minimum documentation to the extent that such documents are included in the fields searched
| | | | |
| --- | --- | --- | --- |
| Jitsuyo Shinan Koho | 1922-1996 | Jitsuyo Shinan Toroku Koho | 1996-2015 |
| Kokai Jitsuyo Shinan Koho | 1971-2015 | Toroku Jitsuyo Shinan Koho | 1994-2015 |

Electronic data base consulted during the international search (name of data base and, where practicable, search terms used)
CAplus/REGISTRY(STN)

### C. DOCUMENTS CONSIDERED TO BE RELEVANT

| Category* | Citation of document, with indication, where appropriate, of the relevant passages | Relevant to claim No. |
| --- | --- | --- |
| Y | WO 2012/169193 A1 (Mitsui Chemicals, Inc.), 13 December 2012 (13.12.2012), claims; paragraphs [0007], [0009], [0017], [0020] to [0026], [0034], [0035], [0036], [0051] to [0053], [0074]; examples & US 2014/0097737 A1 & KR 10-2014-0005361 A & TW 201302916 A | 1-11 |
| Y | JP 3-84060 A (Unitika Ltd.), 09 April 1991 (09.04.1991), claims; pages 1 to 2, upper right column; examples (Family: none) | 1-11 |

[X] Further documents are listed in the continuation of Box C.  [ ] See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 10 August 2015 (10.08.15) | 29 September 2015 (29.09.15) |

| Name and mailing address of the ISA/ | Authorized officer |
| --- | --- |
| Japan Patent Office 3-4-3,Kasumigaseki,Chiyoda-ku, Tokyo 100-8915,Japan | |
| | Telephone No. |

Form PCT/ISA/210 (second sheet) (July 2009)

**INTERNATIONAL SEARCH REPORT**

International application No.

PCT/JP2015/067996

C (Continuation).   DOCUMENTS CONSIDERED TO BE RELEVANT

| Category* | Citation of document, with indication, where appropriate, of the relevant passages | Relevant to claim No. |
|---|---|---|
| Y | JP 53-31758 A  (Emery Industries, Inc.),<br>25 March 1978 (25.03.1978),<br>entire text<br>& US 4066587 A          & DE 2740115 A1<br>& FR 2363604 A1 | 1-11 |
| Y | JP 2004-524422 A  (General Electric Co.),<br>12 August 2004 (12.08.2004),<br>claims; paragraph [0002]<br>& US 2002/0173591 A1    & WO 2002/081564 A1<br>& EP 1414903 A1 | 1-11 |
| P,X | WO 2014/193046 A1  (CHEIL INDUSTRIES INC.),<br>04 December 2014 (04.12.2014),<br>entire text<br>& KR 10-2014-0141227 A | 1-11 |
| P,X | JP 2015-74763 A  (Panasonic Intellectual<br>Property Management Co., Ltd.),<br>20 April 2015 (20.04.2015),<br>claims<br>(Family: none) | 1-11 |
| P,X | US 2014/0187662 A1  (CHEIL INDUSTRIES INC.),<br>03 July 2014 (03.07.2014),<br>entire text<br>& DE 102013226703 A1    & KR 10-2014-0087663 A<br>& CN 103911000 A | 1-11 |
| E,X | WO 2015/091119 A1  (SOLVAY SPECIALTY POLYMWES<br>USA),<br>25 June 2015 (25.06.2015),<br>entire text<br>(Family: none) | 1-11 |
| E,X | WO 2015/091478 A1  (SOLVAY SPECIALITY POLYMERS<br>USA),<br>25 June 2015 (25.06.2015),<br>entire text<br>(Family: none) | 1-11 |
| A | WO 2003/046078 A1  (Toagosei Co., Ltd.),<br>05 June 2003 (05.06.2003),<br>claims; examples<br>& JP 3945481 B          & EP 1454957 A1<br>& KR 10-2004-0066144 A  & CN 1592767 A | 1-11 |
| A | JP 2009-513801 A  (Eastman Chemical Co.),<br>02 April 2009 (02.04.2009),<br>claims; paragraphs [0383], [0420]<br>& WO 2007/053550 A1    & WO 2006/137954 A1<br>& WO 2007/001528 A1    & WO 2007/001529 A1<br>& WO 2007/001531 A1    & WO 2007/001533 A1<br>& WO 2007/001534 A1    & WO 2007/001547 A1 | 1-11 |

Form PCT/ISA/210 (continuation of second sheet) (July 2009)

**INTERNATIONAL SEARCH REPORT**

| International application No. |
| --- |
| PCT/JP2015/067996 |

C (Continuation).    DOCUMENTS CONSIDERED TO BE RELEVANT

| Category* | Citation of document, with indication, where appropriate, of the relevant passages | Relevant to claim No. |
| --- | --- | --- |
| A | WO 2013/030024 A1  (Rhodia Operations),<br>07 March 2013 (07.03.2013),<br>claims; paragraph [0007]; examples<br>& JP 2014-527110 A      & US 2014/0378583 A1<br>& EP 2748259 A1        & CN 103764765 A<br>& KR 10-2014-0069003 A | 1-11 |
| A | WO 2013/026778 A1  (SOLVAY SPECIALTY POLYMERS USA),<br>28 February 2013 (28.02.2013),<br>entire text<br>& EP 2592117 A1 | 1-11 |
| A | JP 2012-136710 A  (Ticona L.L.C.),<br>19 July 2012 (19.07.2012),<br>claims<br>& US 2007/0213458 A1      & US 2011/0310622 A1<br>& US 2013/0158184 A1      & WO 2007/033129 A2<br>& EP 2472603 A1 | 1-11 |
| A | JP 2013-127067 A  (Solvay Specialty Polymers USA, LLC),<br>27 June 2013 (27.06.2013),<br>claims<br>& EP 2634211 A1        & CN 103160079 A<br>& KR 10-2013-0069487 A | 1-11 |
| A | JP 2014-510829 A  (Ticona L.L.C.),<br>01 May 2014 (01.05.2014),<br>claims<br>& US 2014/0128504 A1      & WO 2012/141967 A1<br>& EP 2697298 A1        & CN 103562287 A<br>& KR 10-2014-0027256 A | 1-11 |

Form PCT/ISA/210 (continuation of second sheet) (July 2009)

**EP 3 162 856 A1**

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2004075994 A
- JP 2011241398 A